# EUROPÄISCHE PATENTSCHRIFT

(11) **EP 1 271 816 B1**
(45) Veröffentlichungstag und Bekanntmachung des Hinweises auf die Patenterteilung: **21.12.2011**
(21) Anmeldenummer: 02013392.2
(22) Anmeldetag: 19.06.2002
(51) Int. Cl.: H04H 20/22

(54) **Verfahren zum durchführen einer Frequenzsuche in einem Rundfunkempfänger**
Method for performing a frequency search in a radio receiver
Procédé de recherche d'une fréquence dans un récepteur radio

(30) Priorität: 21.06.2001 DE 10130052
(43) Veröffentlichungstag der Anmeldung: 02.01.2003
(73) Patentinhaber: Harman Becker Automotive Systems GmbH, 76307 Karlsbad (DE)
(72) Erfinder: Benz, Chistoph, Dipl.-Ing., 77797 Ohlsbach (DE); Gierl, Stefan, Dipl.-Ing., 76133 Karlsruhe (DE); Körner, Andreas, Dipl.-Ing., 76137 Karlsruhe (DE)
(74) Vertreter: Patentanwälte Westphal, Mussgnug & Partner

(56) Entgegenhaltungen:
- EP-A- 0 845 873
- WO-A-01/56178
- DE-A1- 19 734 168
- GB-A- 2 122 827

## Beschreibung

Die vorliegende Erfindung betrifft ein Verfahren zum Steuern der Suche nach einer Alternativfrequenz zu einer aktuellen Hör-Empfangsfrequenz in einem Rundfunkempfänger sowie einen an ein solches Verfahren angepassten Rundfunkempfänger.

Unter der Bezeichnung Autobest sind Rundfunkempfänger für Kraftfahrzeuge bekannt, bei denen eine Steuereinheit selbsttätig das empfangbare Frequenzband nach Alternativfrequenzen zu einer vom Benutzer an dem Empfänger eingestellten Hör-Empfangsfrequenz absucht, um in dem Fall, dass die Empfangsqualität bei der Hör-Empfangsfrequenz zu stark abnimmt oder ein Sender mit gleichem Programminhalt und besserer Empfangsqualität bei einer anderen Frequenz gefunden wird, den Empfänger automatisch auf diese Frequenz umschalten zu können.

Die Suche nach für eine solche Umschaltung geeigneten Alternativfrequenzen erfordert, dass ein Empfangsteil zeitweilig auf eine von der jeweiligen Hör-Empfangsfrequenz verschiedene Untersuchungsfrequenz abgestimmt wird, um deren Empfangsfeldstärke beurteilen zu können und gegebenenfalls anhand von Codesignalen wie etwa dem bekannten PI-Code, beurteilen zu können, ob das auf der Untersuchungsfrequenz empfangene Programm mit dem bei der Hör-Empfangsfrequenz empfangenen identisch ist.

Wenn der Rundfunkempfänger nur über ein einziges Empfangsteil verfügt, muss jedes Mal, wenn eine Untersuchungsfrequenz eingestellt wird, die Audio-Wiedergabe ausgetastet werden, was vom Zuhörer als störend empfunden wird.

Dieses Problem lässt sich zwar vermeiden, wenn ein Rundfunkempfänger mit wenigstens zwei Empfangsteilen ausgerüstet wird, von denen einer auf das Hör-Empfangssignal abgestimmt bleiben kann, während mit dem anderen diverse Untersuchungsfrequenzen durchgeprüft werden, doch ist ein solches Gerät notwendigerweise deutlich teurer als eines mit einem einzigen Empfangsteil.

Die Veröffentlichung WO 01/56178 A2 beschreibt ein Verfahren zum Verdecken von Unterbrechungen der Wiedergabe empfangener Rundfunksignale, welches sich dadurch auszeichnet, dass längere Unterbrechungen nur dann zugelassen werden, wenn erstens die Modulation des aktuell empfangenen Rundfunkprogramms als Sprache erkannt wird und zweitens im empfangenen Rundfunksignal eine Modulationspause erkannt wird. Dies erlaubt zum Beispiel die Auswertung bzw. Prüfung von RDS-Informationen auf einer zu der aktuell empfangenen Sendefrequenz alternativen Sendefrequenz.

Die Veröffentlichung EP 0 845 873 A1 betrifft ein ähnliches Verfahren zum Abstimmen eines Rundfunkempfängers auf Alternativfrequenzen während Pausen in einem aktuell empfangenen Rundfunksignal.

Die Veröffentlichung GB 2 122 827 A beschreibt einen Rundfunkempfänger, in dem als Ausgangssignal ein Rauschsignal ausgegeben wird, solange der Empfänger nicht korrekt auf ein Rundfunkprogramm abgestimmt ist.

Aufgabe der vorliegenden Erfindung ist, ein Verfahren zum Steuern der Suche nach einer Alternativfrequenz anzugeben, das mit einem Rundfunkempfänger mit einem einfachen Empfangsteil durchführbar ist und das dennoch hörbare Unterbrechungen der Audio-Wiedergabe in Zeiten, in denen das Empfangsteil auf eine Untersuchungsfrequenz abgestimmt ist, vermeidet oder zumindest minimiert.

Die Aufgabe wird gelöst durch ein Verfahren nach Anspruch 1 bzw. einen Rundfunkempfänger nach Anspruch 9.

Der Grundgedanke der vorliegenden Erfindung ist, das Audiosignal bei der Hör-Empfangsfrequenz auszuwerten, um Zeiten zu finden, in denen der Empfänger kurzfristig auf eine Untersuchungsfrequenz umgeschaltet werden kann, ohne dass dies für einen Zuhörer zu einer empfindlichen Beeinträchtigung des Hörgenusses führt.

Aus einer solchen Überwachung ergibt sich mehrfacher Nutzen. Bei einem herkömmlichen Autobest-Empfänger mit einfachem Empfangsteil wird man im allgemeinen die Suche nach Alternativfrequenzen vermeiden, so lange der Empfang bei der eingestellten Hör-Empfangsfrequenz gut ist, denn anderenfalls würde diese Suche nach den Alternativfrequenzen zu Unterbrechungen in der Audio-Ausgabe führen, die dem Zuhörer den Eindruck eines schlechten, instabilen Empfangs vermitteln. Erst wenn der Empfang kritisch schlecht wird und die mangelnde Empfangsqualität zu Rauschen und Aussetzern in der Audio-Wiedergabe führen, kann die Suche nach Alternativfrequenzen durchgeführt werden, ohne dass die dadurch verursachten Aussetzer der Audio-Wiedergabe übermäßig auffallen. Bis es soweit ist, hat der Zuhörer aber schon eine Zeitlang eine gestörte Audio-Ausgabe ertragen müssen.

Wenn aber erfindungsgemäß diejenigen Zeiten für die Suche nach Alternativfrequenzen genutzt werden, in denen eine Unterbrechung der Audio-Ausgabe auch bei gutem Empfang für einen Zuhörer nicht oder kaum wahrnehmbar ist, so kann diese Suche auch bereits durchgeführt werden, während die Empfangsbedingungen noch gut sind, und eine neue Hör-Empfangsfrequenz kann, sofern sie gefunden wird, eingestellt werden, noch bevor es zu Aussetzern und Störungen bei der alten Frequenz kommt. Kurz gesagt wird durch die Erfindung nicht nur vermieden, dass Aussetzer bei der Audio-Wiedergabe, die während der Suche nach Alternativfrequenzen unvermeidlich sind, einen Zuhörer stören, sondern es wird insgesamt eine bessere Empfangsqualität erreicht, da der Wechsel auf eine neue Hör-Empfangsfrequenz bereits durchgeführt werden kann, noch bevor der Empfang bei der alten so schlecht geworden ist, dass er zu störenden Aussetzern führt.

Die Auswertung des Audiosignals erfolgt zweckmäßigerweise durch Überwachen von dessen Amplitude. Dabei wird einer ersten Alternative zufolge eine Zeit als für die Suche nach einer Alternativfrequenz geeignet festgelegt, wenn zu dieser Zeit die Amplitude des Audiosignals unter einem ersten Grenzwert liegt.

Dieser erste Grenzwert kann anhand des Hör-Empfangssignals festgelegt werden, insbesondere so, dass er dem durch die Empfangsfeldstärke bestimmten Rauschpegel des Signals entspricht. Auf diese Weise beschränkt sich die Suche nach Alternativfrequenzen auf Pausen im Audiosignal, in denen eine Unterbrechung der Audio-Ausgabe einem Zuhörer nicht auffallen kann.

Um die Unterbrechung noch wirksamer zu verbergen, kann vorgesehen werden, dass in der Zeit, in der der Empfänger nicht auf die Hör-Empfangsfrequenz abgestimmt ist, als Audio-Ausgabe ein Rauschsignal ausgegeben wird, dessen Amplitude dem Rauschpegel des Senders bei der Hör-Empfangsfrequenz entspricht.

Wenn die Suche nach Alternativfrequenzen jeweils in einer Pause des Signals bei der Hör-Empfangsfrequenz stattfindet, so ist zu erwarten, dass ein Signal bei einer Untersuchungsfrequenz, auf die das Empfangsteil abgestimmt wird, ebenfalls eine Pause überträgt. Wenn die Amplitude des bei der Untersuchungsfrequenz empfangenen Audiosignals über der Rauschgrenze liegt, so bedeutet dies, dass der Sender des Signals bei der Untersuchungsfrequenz und der des Signals bei der Hör-Empfangsfrequenz nicht identisch sind, dass also die Untersuchungsfrequenz keine geeignete Alternativfrequenz ist, oder dass die Pause im Signal bei der Hör-Empfangsfrequenz beendet ist. In einem solchen Fall wird die Überprüfung der Eignung der Untersuchungsfrequenz sofort abgebrochen, und der Empfänger wird wieder auf die Hör-Empfangsfrequenz abgestimmt.

Für die Suche nach Alternativfrequenzen können nicht nur Pausen des Empfangssignals verwendet werden, sondern auch Verdeckungseffekte. Wenn sich die Amplitude der Audio-Ausgabe stark ändert, so sind kurzzeitige Unterbrechungen für einen Zuhörer nicht wahrnehmbar. Es ist daher alternativ oder auch ergänzend zu der oben beschriebenen Art der Amplitudenüberwachung möglich, die relative Änderung der Amplitude des Audiosignals zu verfolgen und Zeiten, in denen die relative Änderung der Amplitude außerhalb eines Sollintervalls liegt, als geeignet für die Suche nach einer Alternativfrequenz anzusehen. Eine einfache Möglichkeit, solche Änderungen zu erfassen ist das Ermitteln einer langfristigen mittleren Leistung des Audiosignals durch Mitteln von dessen Amplitude mit einer ersten Zeitkonstante und das Ermitteln einer kurzfristigen Leistung, das Bilden des Quotienten dieser Größe und das Annehmen einer Zeit, in der der Quotient außerhalb eines Sollintervalls liegt, als für die Suche nach einer Alternativfrequenz geeignet. Um die Zuverlässigkeit dieser Beurteilung zu verbessern, kann als zusätzliches Kriterium vorgesehen werden, dass eine Zeit nur dann als für die Suche nach einer Alternativfrequenz geeignet angesehen wird, wenn genau eine der Leistungen oberhalb eines dritten Sollintervalls oder unterhalb dieses dritten Sollintervalls liegt.

Um zu verhindern, dass kurzfristige, durch Rauschen bedingte Leistungsschwankungen zu einer Fehlbeurteilung führen, ist es zweckmäßig, dass die kurzfristige Leistung nicht etwa eine momentane Leistung, sondern ebenfalls eine mittlere Leistung des Audiosignals ist, die allerdings mit einer zweiten Zeitkonstante gemittelt ist, die kleiner als die erste ist. Das Verhältnis der zwei Zeitkonstanten zueinander kann im Bereich 1:5 bis 1:20, vorzugsweise bei 1:10, liegen.

Im Falle der Nutzung von Verdeckungseffekten sollte die Zeitdauer, in der der Empfänger auf die Untersuchungsfrequenz abgestimmt ist, kürzer als 10 ms, vorzugsweise in einer Größenordnung von 1 bis 3 ms, sein, damit die Unterbrechung nicht auffällig hörbar wird. Eine solche Zeitspanne ist im allgemeinen nicht ausreichend, um einen PI-Code bei der Untersuchungsfrequenz zu erfassen und auszuwerten; sie genügt aber im allgemeinen, um die Empfangsfeldstärke zu beurteilen. Wenn diese kleiner ist als bei der Hör-Empfangsfrequenz, so ist die Untersuchungsfrequenz auf jeden Fall als Alternativfrequenz ungeeignet. Wenn sie größer ist, kann zu einem späteren Zeitpunkt eine zweite, längere Messung bei der Untersuchungsfrequenz durchgeführt werden, um ihre Eignung als Alternativfrequenz abschließend zu beurteilen. Hierfür kann z.B. wie oben beschrieben eine Pause des Audiosignals genutzt werden. Es ist auch möglich, eine solche Messung in herkömmlicher Weise zu einem willkürlich ohne Berücksichtigung der Amplitude des Empfangssignals festgelegten Zeitpunkt durchzuführen und dann eine Unterbrechung der Audio-Ausgabe in Kauf zu nehmen; da mit dem erfindungsgemäßen Verfahren bereits eine Vielzahl von Untersuchungsfrequenzen vorab als ungeeignet ausgeschlossen werden können, reduzieren sich auf diese Weise dennoch Anzahl und Dauer der Unterbrechungen erheblich.

Weitere Merkmale und Vorteile der Erfindung ergeben sich aus der nachfolgenden Beschreibung von Ausführungsbeispielen mit Bezug auf die beigefügten Figuren. Es zeigen:
- Fig. 1: ein stark schematisiertes Blockdiagramm eines erfindungsgemäßen Rundfunkgeräts;
- Fig. 2: ein Flussdiagramm eines von der Steuereinheit des Rundfunkgerätes aus Fig. 1 durchgeführten Steuerverfahrens; und
- Fig. 3: eine Darstellung eines momentanen Inhalts des Speichers des Rundfunkgeräts aus Fig. 1.

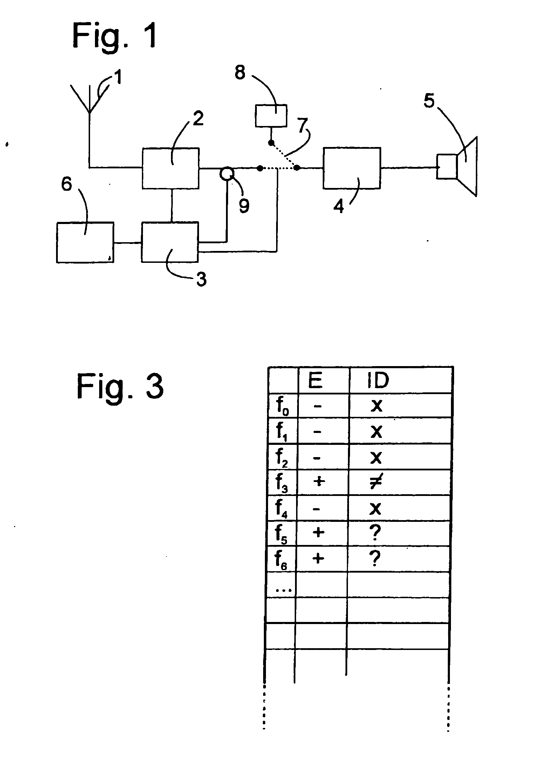

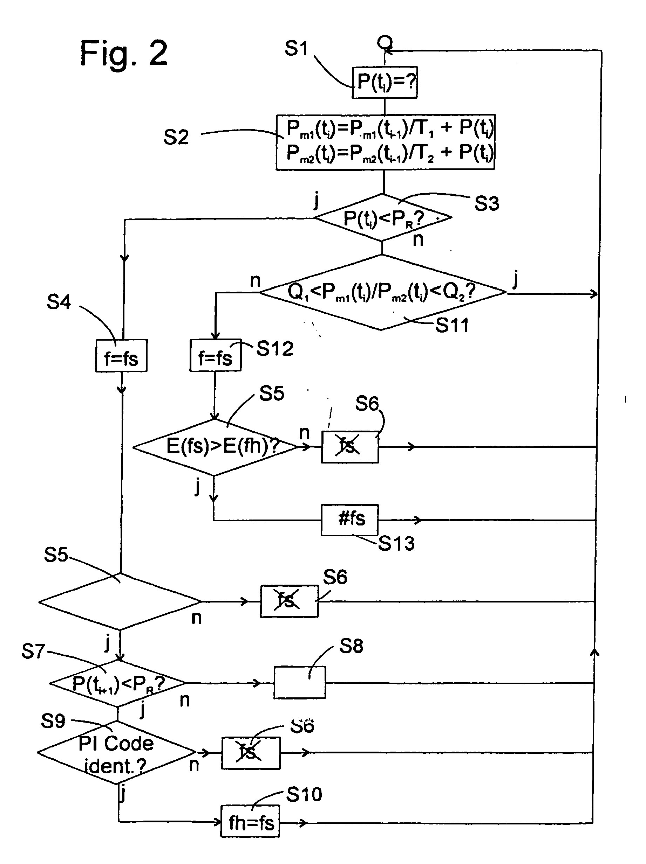

Fig. 1 zeigt anhand eines stark vereinfachten Blockdiagramms ein Autobest-Autoradio als Anwendungsbeispiel der vorliegenden Erfindung. Das Autoradio umfasst ein mit einer Antenne 1 verbundenes Empfangsteil 2, das unter der Kontrolle einer Steuereinheit 3 jeweils auf eine von der Steuereinheit 3 vorgegebene Funkfrequenz abstimmbar ist und ein bei dieser Frequenz empfangenes Audiosignals an einen Ausgang liefert, einen Verstärker 4 für das Audiosignal, dessen Eingang über einen Schalter 7 unter der Kontrolle der Steuereinheit 3 wahlweise mit dem Ausgang des Empfangsteils 2 oder mit einem Rauschgenerator 8 verbindbar ist und das an seinem Eingang empfangene Signal in verstärkter Form an einen Lautsprecher 5 liefert, eine Messschaltung 9, die an den Ausgang des Empfangsteils 2 angeschlossen ist und ein für die Amplitude des Audio-Ausgangssignals des Empfangsteils repräsentatives Messsignal an die Steuereinheit 3 liefert, und eine Frequenzspeichereinheit 6, auf deren Funktion und Speicherinhalte in Verbindung mit den Figs. 2 und 3 noch genauer eingegangen wird.

Das Empfangsteil 2 ist durch einen Benutzer auf eine als Hör-Empfangsfrequenz bezeichnete Frequenz eines Senders abstimmbar, dessen Programm der Hörer hören möchte. Wenn sich ein Fahrzeug, in dem das erfindungsgemäße Autoradio eingebaut ist, bewegt, ändern sich die Empfangsbedingungen bei der eingestellten Hör-Empfangsfrequenz, und es kann vorkommen, dass das vom Benutzer eingestellte Programm auf einer anderen Funkfrequenz mit besserer Qualität empfangbar ist.

Fig. 2 veranschaulicht ein von der Steuereinheit 3 durchgeführtes Arbeitsverfahren, das gewährleistet, dass das Autoradio das vom Benutzer gewünschte Programm - bis auf kurze Übergangsphasen - immer auf derjenigen Funkfrequenz empfängt, die die besten Empfangsbedingungen bietet. Das Verfahren der Fig. 2 wird zyklisch wiederholt.

In einem ersten Schritt S1 des Verfahrens, zu einem Zeitpunkt tᵢ, fragt die Steuereinheit 3 die von der Messschaltung 9 gemessene Leistung oder Amplitude P(tᵢ) des empfangenen Audiosignals ab. Da es sich bei Leistung und Amplitude für die vorliegende Erfindung um Äquivalente handelt, wird im folgenden lediglich der Begriff "Leistung" verwendet.

Anhand dieses Messwerts werden in Schritt S2 zwei gleitende Mittelwerte Pₘ₁(tᵢ) bzw. Pₘ₂(tᵢ) berechnet, die sich hinsichtlich der Zeitkonstanten t₁, t₂ der Mittelung unterscheiden. Typische Zeitkonstanten für die Mittelwertberechnung liegen hierbei in der Größenordnung von 5 bis 10 ms für die Langzeitmittelung (Zeitkonstante t₁) und 0,5 bis 1 ms für die Kurzzeitmittelung (Zeitkonstante t₂).

Im anschließenden Schritt S3 wird überprüft, ob die momentane gemessene Leistung P(tᵢ) - oder alternativ auch die kurzzeitgemittelte Leistung Pₘ₂(tᵢ) unterhalb eines Grenzwerts P_{R} liegt.

Der Grenzwert P_{R} ist eine Funktion der Empfangsfeldstärke bei der Hör-Empfangsfrequenz und ist geringfügig größer als die Rauschleistung des Audiosignals des Empfangsteils 2, die sich ergibt, wenn ein Funksignal, das Stille repräsentiert, mit der Empfangsfeldstärke des aktuell eingestellten Hörsignals empfangen wird. Wenn die momentane Leistung P(tᵢ) (oder die kurzzeitgemittelte Leistung Pₘ₂(tᵢ)) unter den Grenzwert P_{R} abfällt, so bedeutet dies, dass eine Pause in dem Funksignal bei der Hör-Empfangsfrequenz übertragen wird.

Wenn dies der Fall ist, verzweigt das Verfahren zu Schritt S4, wo die Steuereinheit 3 das Empfangsteil 2 auf eine von ihr ausgewählte Suchfrequenz fs abstimmt. Gleichzeitig legt die Steuereinheit 3 den Schalter 7 um, so dass der Eingang des Verstärkers 4 nicht mehr mit dem Ausgang des Empfangsteils 2 sondern mit dem Rauschgenerator 8 verbunden ist, der ein gleichbleibendes Rauschen mit der Leistung P_{R} liefert. Diese Umschaltung ist für einen Zuhörer nicht wahrnehmbar. Die Steuereinheit überprüft nun zunächst, ob die Feldstärke E(fs) bei der eingestellten Suchfrequenz fs größer ist als bei der Hör-Empfangsfrequenz fh, auf die das Autoradio zuvor abgestimmt war (S5). Wenn die Feldstärke bei der Suchfrequenz fs kleiner als bei der Hör-Empfangsfrequenz fh ist, so ist die Suchfrequenz fs offensichtlich keine geeignete Alternativfrequenz für die aktuelle Hör-Empfangsfrequenz fh und wird in Schritt S6 aus einer in der Frequenzspeichereinheit 6 geführten Liste möglicher Alternativfrequenzen gestrichen.

Wenn die Empfangsfeldstärke der Suchfrequenz größer ist als die der Hör-Empfangsfrequenz, so bleibt das Empfangsteil 2 zunächst auf die Suchfrequenz fs abgestimmt, um bei dieser Frequenz RDS-Signale oder einen PI-Code des Senders zu bestimmen, der eine Entscheidung über dessen Identität zulässt, und eine Beurteilung gestattet, ob das Programm des Senders bei der Suchfrequenz fs mit dem des Senders bei der Hör-Empfangsfrequenz fh identisch ist.

Während dieser Zeit überwacht die Steuereinheit 3 die Amplitude des bei der Untersuchungsfrequenz empfangenen Signals (S7). Wenn die Leistung P(tᵢ₊₁) des Signals bei der Untersuchungsfrequenz unter dem Grenzwert bleibt, so wartet die Steuereinheit bis zum Ablauf einer vorgegebenen Maximalzeitspanne ab, ob eine PI-Codeinformation oder dergleichen empfangen wird.

Wird eine Codeinformation rechtzeitig empfangen, so entscheidet die Steuereinheit 3 anhand der Codeinformation in Schritt S9, ob der Sender bei der Suchfrequenz fs mit dem Sender bei der Hör-Empfangsfrequenz fh identisch ist oder nicht. Bei Nichtidentität wird die Suchfrequenz fs aus der Liste der möglichen Alternativfrequenzen gestrichen (S6). Stellen sich die Sender als identisch heraus, so tritt die Suchfrequenz fs, auf die das Empfangsteil 2 gegenwärtig abgestimmt ist, an die Stelle der Hör-Empfangsfrequenz fh (S10), d.h. die Steuereinheit 3 schaltet das Empfangsteil nicht auf die bisherige Hör-Empfangsfrequenz zurück, sondern schaltet lediglich erneut den Schalter 7 um, so dass das Audiosignal des Empfangsteils 2 wieder zum Verstärker 4 gelangt.

Stellt sich in Schritt S7 heraus, dass die Leistung P(tᵢ₊₁) den Grenzwert P_{R} übersteigt, so kann dies bedeuten, dass der Sender bei der Untersuchungsfrequenz mit dem bei der Hör-Empfangsfrequenz nicht identisch ist, oder, falls die Sender bei beiden Frequenzen identisch sein sollten, die Pause im Signal zu Ende ist. In beiden Fällen ist es notwendig, zur Hör-Empfangsfrequenz zurückzuschalten, damit das Audiosignal wieder ausgegeben werden kann. Für die weitere Verarbeitung im Schritt S8 gibt es mehrere Alternativen.

Eine erste Alternative ist, dass das Empfangsteil 2 auf die Hör-Empfangsfrequenz zurückgeschaltet wird, ohne dass eine Änderung an der Liste möglicher Alternativfrequenzen vorgenommen wird. Dies erlaubt eine erneute Untersuchung der gleichen Frequenz, wenn zu einem späteren Zeitpunkt abermals eine Pause im Signal auftritt.

Als Weiterbildung dieser Alternative ist möglich, dass die Steuereinheit 3 zählt, wie oft der Schritt S8 für eine gegebene Untersuchungsfrequenz durchgeführt wurde und die Frequenz aus der Liste streicht, wenn ein Grenzwert überschritten ist.

Eine zweite Alternative ist, die Untersuchungsfrequenz bereits bei erstmaliger Durchführung des Schritts S8 aus der Liste zu streichen. Die damit verbundene geringe Gefahr, eine brauchbare Alternativfrequenz zu übersehen, kann im Interesse einer einfachen Implementierung hingenommen werden, zumal es ohnehin von Zeit zu Zeit notwendig ist, die Liste zurückzusetzen, um mit der Fortbewegung des Fahrzeugs verbundene Änderungen in der Empfangssituation des Autoradios berücksichtigen zu können.

Wenn die Überprüfung des Schritts S3 ergibt, dass keine Pause des Audiosignals vorliegt, so könnte dennoch eine Verdeckungssituation gegeben sein, in der eine zeitweilige Unterbrechung des Audiosignals am Lautsprecher von einem Zuhörer kaum wahrgenommen wird. Eine solche Verdeckungssituation liegt dann vor, wenn die Leistung des Audiosignals zeitweilig stark ansteigt oder abfällt. Sie ist für die Steuereinheit 3 in Schritt S11 z.B. daran erkennbar, dass der Quotient der zwei Leistungen Pₘ₁(tᵢ) und Pₘ₂(tᵢ) nicht innerhalb eines durch zwei Grenzwerte Q₁, Q₂ definierten Intervalls liegt, wobei Q₁ wesentlich kleiner und Q₂ wesentlich größer als 1 ist. So lange der Quotient innerhalb dieses Intervalls liegt, kann die Audio-Wiedergabe nicht unterbrochen werden, ohne einen Hörer zu stören; in diesem Fall kehrt das Verfahren zum Ausgangspunkt zurück und wartet den nächsten Zeitpunkt tᵢ ab, an dem eine Messung der momentanen Leistung des Audiosignals ansteht.

Liegt der Quotient außerhalb des Intervalls, so wählt die Steuereinheit 3 wiederum eine Suchfrequenz fs, auf die sie das Empfangsteil 2 abstimmt, und unterbricht die Audio-Wiedergabe mit Hilfe des Schalters 7 in Schritt S12. Anschließend wird, wie oben mit Bezug auf Schritte S5, S6 beschrieben, die Empfangsfeldstärke E(fs) bei der Suchfrequenz fs mit der Empfangsfeldstärke E(fh) bei der zuvor eingestellten Hör-Empfangsfrequenz fh verglichen und, falls erstere kleiner ist, die Suchfrequenz fs aus der Liste möglicher Alternativfrequenzen gestrichen.

Einer Weiterbildung des Verfahrens zufolge wird in Schritt S11 zusätzlich noch überprüft, ob von den zwei Mittelwerten Pₘ₁(tᵢ) und Pₘ₂(tᵢ) genau eine oberhalb und/oder genau eine unterhalb eines Sollintervalls liegt. Diese zusätzliche Maßnahme erlaubt es, das Intervall [Q₁, Q₂] kleiner zu wählen als wenn nur das Verhältnis der Leistungen Pₘ₁(tᵢ) und Pₘ₂(tᵢ) untersucht wird und so bei gleichbleibender Zuverlässigkeit mehr Verdeckungssituationen zu erkennen.

Falls die Empfangsfeldstärke E(fs) bei der Suchfrequenz fs die größere ist, so genügt im Falle einer Verdeckungssituation die Zeitspanne, in der die Audio-Wiedergabe unhörbar unterbrochen werden kann, nicht, um auch noch den Empfang eines Codesignals auf der Suchfrequenz abzuwarten und anhand von diesem eine Entscheidung über die Identität der Sender zu treffen. Die Steuereinheit markiert daher lediglich die Suchfrequenz fs in Schritt S13 als eine potentiell interessante Alternativfrequenz, die in einer kommenden Pause des Hör-Empfangsfrequenzsignals genauer untersucht werden sollte.

Die Liste der möglichen Alternativfrequenzen ist in der Frequenzspeichereinheit 6 aufgezeichnet; Fig. 3 zeigt ihre Struktur. Sie besteht aus einer Serie von Feldern, die in ansteigender oder absteigender Reihenfolge der ihnen zugeordneten Frequenzen geordnet sind. Jeder Frequenz, auf die die Steuereinheit 3 bei einer Durchmusterung des Frequenzbandes auf der Suche nach Alternativfrequenzen das Empfangsteil 2 abstimmt, ist ein Feld zugeordnet.

Vor der erstmaligen Durchführung des mit Bezug auf Fig. 2 beschriebenen Verfahrens sind alle Felder leer.

Bei dem in Fig. 3 exemplarisch gezeigten Inhalt der Liste hat die Steuereinheit 3 die Suche nach Alternativfrequenzen mit der Frequenz f₀ begonnen; die Messung hat ergeben, dass die Empfangsfeldstärke E(f₀) kleiner war als E(fh) bei der Hör-Empfangsfrequenz fh. Das Ergebnis ist in der Liste durch ein Symbol (-) in der mit E bezeichneten Spalte festgehalten. Dieses Messergebnis macht eine Überprüfung einer eventuellen Identität der Sender bei f₀ und fh überflüssig, dies ist in der Spalte ID für die Frequenz f₀ durch ein Kreuzchen (x) symbolisiert. Feldstärkemessungen bei Frequenzen f₁, f₂ haben das gleiche Ergebnis geliefert.

Bei der Frequenz f₃ wurde eine größere Feldstärke als bei Hör-Empfangsfrequenz fh gemessen, dargestellt als + in der Spalte E. Eine für diese Frequenz durchgeführte Überprüfung des PI-Codes hat ergeben, dass die Sender beider Frequenzen f₃ und fh nicht identisch sind, dargestellt als Ungleichzeichen in der Spalte ID. (Der tatsächlich in der Spalte ID in der Frequenzspeichereinheit 6 eingetragene Datenwert könnte für f₃ der gleiche wie für die vorherigen Frequenzen sein, da es für die Zwecke der Erfindung lediglich darauf ankommt, die Nichteignung der Frequenz f₃ als Alternativfrequenz festzuhalten, nicht aber, aus welchem Grund sie nicht geeignet ist.)

Die Frequenz f₄ hat sich wiederum wegen unzureichender Empfangsfeldstärke als ungeeignet erwiesen.

Die Frequenzen f₅, f₆ weisen eine höhere Empfangsfeldstärke auf als fₕ, es ist allerdings noch nicht bekannt, ob die Sender bei diesen Frequenzen mit dem Sender bei der Hör-Empfangsfrequenz fh identisch sind. Ein Grund dafür kann sein, dass die Feldstärken von f₅, f₆ in einer Verdeckungssituation gemessen wurden, oder dass sie zwar in einer Pause gemessen wurden, dass aber die Messung abgebrochen und der Schritt S8 durchgeführt wurde. Ausgehend von dem hier gezeigten Zustand der Frequenzliste wird die Steuereinheit 3 im Falle einer Verdeckungssituation als neue Suchfrequenz fs die nächste Frequenz f₇ der Liste wählen, für die noch keine Feldstärkenmessung vorliegt. Im Falle einer Pause wird als Suchfrequenz f₅ gewählt, die erste unter den Frequenzen mit hoher Empfangsfeldstärke, für die die Senderidentität noch unbekannt ist.

## Patentansprüche

1. Verfahren zum Steuern der Suche nach einer Alternativfrequenz zu einer aktuellen Hör-Empfangsfrequenz (fₕ) in einem Rundfunkempfänger, der aus einem bei der Hör-Empfangsfrequenz (fₕ) empfangenen Funksignal ein Audiosignal ableitet,
wobei der Empfang des Funksignals bei der Hör-Empfangsfrequenz (fₕ) zeitweilig unterbrochen wird, um den Rundfunkempfänger auf ein Funksignal bei einer Untersuchungsfrequenz (fₛ) abzustimmen und zu überprüfen, ob die Untersuchungsfrequenz (fₛ) als Alternativfrequenz geeignet ist,
wobei das Audiosignal ausgewertet wird, um Zeiten festzulegen, in denen eine Unterbrechung der Ausgabe des Audiosignals für einen Hörer nicht oder wenig wahrnehmbar ist,
wobei die Auswertung das Überwachen einer zu der Amplitude oder Leistung des Audiosignals proportionalen Größe (Pₘ₁(tᵢ), Pₘ₂(tᵢ)) beinhaltet,
**dadurch gekennzeichnet, dass** eine Zeit als für die Suche nach einer Alternativfrequenz geeignet festgelegt wird, wenn die relative Änderung der proportionalen Größe (Pₘ₁(tᵢ)/Pₘ₂(tᵢ)) zu dieser Zeit (tᵢ) außerhalb eines Sollintervalls liegt, wobei die Abstimmung auf die Untersuchungsfrequenz (fₛ) jeweils zu einer so festgelegten Zeit durchgeführt wird.

2. Verfahren nach Anspruch 1, bei dem das Überwachen
das Ermitteln eines langfristigen Mittelwerts der proportionalen Größe (Pₘ₁) des Audiosignals durch Mitteln mit einer ersten Zeitkonstante und
das Ermitteln einer kurzfristigen proportionalen Größe (Pₘ₂) umfasst,
wobei eine Zeit (tᵢ) als für die Suche nach einer Alternativfrequenz geeignet festgelegt wird, wenn der Quotient aus kurzfristiger und langfristiger proportionaler Größe (Pₘ₁(tᵢ)/Pₘ₂(tᵢ)) außerhalb eines zweiten Sollintervalls liegt.

3. Verfahren nach Anspruch 2, bei dem eine Zeit nur dann als für die Suche nach einer Alternativfrequenz geeignet festgelegt wird, wenn zusätzlich genau eine der proportionalen Größen (Pₘ₁, Pₘ₂) oberhalb eines dritten Sollintervalls und/oder genau eine der proportionalen Größen unterhalb des dritten Sollintervalls liegt.

4. Verfahren nach Anspruch 2 oder 3, bei dem die erste Zeitkonstante (T₁) zwischen 2 und 20, vorzugsweise zwischen 5 und 10 ms beträgt.

5. Verfahren nach einem der Ansprüche 2 bis 4, bei dem die kurzfristige proportionale Größe (Pₘ₂) eine mit einer zweiten Zeitkonstante (T₂) gemittelte proportionale Größe des Audiosignals ist, wobei die zweite Zeitkonstante (T₂) kleiner als die erste (T₁) ist.

6. Verfahren nach Anspruch 5, bei dem die zweite Zeitkonstante (T₂) zwischen 0,2 und 2, vorzugsweise zwischen 0,5 und 1 ms beträgt.

7. Verfahren nach einem der Ansprüche 1 bis 6, bei dem die Zeitdauer der Abstimmung auf die Untersuchungsfrequenz (fs) weniger als 10 ms beträgt.

8. Verfahren nach Anspruch 7, bei dem während der Abstimmung auf die Untersuchungsfrequenz (fₛ) nur die Empfangsfeldstärke gemessen wird, undbei dem, wenn die Empfangsfeldstärke (E(fₛ)) bei der Untersuchungsfrequenz (fₛ) kleiner ist als bei der Hör-Empfangsfrequenz (fₕ), die Untersuchungsfrequenz (fₛ) als ungeeignete Alternativfrequenz beurteilt wird.

9. Rundfunkempfänger mit
einem auf unterschiedliche Frequenzen (fₛ, fₕ) abstimmbares Empfangsteil (2), das dazu ausgebildet ist, ein Audiosignal auszugeben,
eine Messschaltung (9), zum Überwachen einer zu der Leistung oder der Amplitude des Audiosignals proportionalen Größe (Pₘ₁(tᵢ), Pₘ₂(tᵢ)), und mit
einer mit der Messschaltung (9) verbundenen Steuereinheit (3), die dazu ausgebildet ist,
das Audiosignal auszuwerten, um Zeiten festzulegen, in denen eine Unterbrechung der Ausgabe des Audiosignals für einen Hörer nicht oder wenig wahrnehmbar ist, und
zu ermitteln, ob eine relative Änderung der proportionalen Größe (Pₘ₁(tᵢ)/Pₘ₂(tᵢ)) außerhalb eines Sollintervalls liegt, **dadurch gekennzeichnet, dass**
eine Zeit als für die Suche geeignet festgelegt wird, wenn die relative Änderung zu dieser Zeit (tᵢ) außerhalb des Sollintervalls liegt, sodass das Empfangsteil (2) zur Suche nach einer Alternativfrequenz auf eine Untersuchungsfrequenz (fₛ) zu einer so festgelegten Zeit abgestimmt wird.

10. Rundfunkempfänger nach Anspruch 9, **gekennzeichnet durch** einen Rauschgenerator (8) zum Liefern eines Audio-Ausgangssignals, wenn das Empfangsteil (2) auf eine von einer eingestellten Hör-Empfangsfrequenz (fₕ) abweichende Untersuchungsfrequenz (fₛ) abgestimmt ist.

## Claims

1. A method of controlling the search for an alternative frequency to a current listening reception frequency (fₕ) in a radio receiver, which derives an audio signal from a radio signal received at the listening reception frequency (fₕ), wherein the reception of the radio signal at the listening reception frequency (fₕ) is temporarily interrupted in order to tune the radio receiver to a radio signal at a test frequency (fₛ) and to check whether the test frequency (fₛ) is suitable as the alternative frequency, wherein the audio signal is analysed in order to determine times in which an interruption of the emission of the audio signal is not or only slightly perceptible to a listener, wherein the analysis includes the monitoring of a parameter (Pₘ₁(tᵢ), Pₘ₂(tᵢ)) proportional to the amplitude or power of the audio signal, **characterised in that** a time is determined as suitable for the search for an alternative frequency when the relative change in the proportional parameter (Pₘ₁(tᵢ)/Pₘ₂(tᵢ)) at this time (tᵢ) lies outside a desired range, wherein the tuning to the test frequency (fₛ) is performed in each case at a time thus determined.

2. A method as claimed in Claim 1, in which the monitoring includes the determination of a long term mean value of the proportional parameter (Pₘ₁) of the audio signal by means with a first time constant and the determination of a short term proportional parameter (Pₘ₂), wherein a time (tᵢ) is determined to be suitable for the search for an alternative frequency when the quotient of the short term and long term proportional parameters (Pₘ₁(tᵢ)/Pₘ₂(tᵢ)) lies outside a second desired range.

3. A method as claimed in Claim 2, in which a time is only determined to be suitable for the search for an alternative frequency when additionally precisely one of the proportional parameters (Pₘ₁, Pₘ₂) lies above a third desired range and/or precisely one of the proportional parameters lies below the third desired range.

4. A method as claimed in Claim 2 or 3, in which the first time constant (T₁) is between 2 and 20, preferably between 5 and 10 ms.

5. A method as claimed in one of Claims 2 to 4, in which the short term proportional parameter (Pₘ₂) is a proportional parameter of the audio signal averaged with a second time constant (T₂), wherein the second time constant (T₂) is smaller than the first (T₁).

6. A method as claimed in Claim 5, in which the second time constant (T₂) is between 0.2 and 2, preferably between 0.5 and 1 ms.

7. A method as claimed in one of Claims 1 to 6, in which the duration of the tuning to the test frequency (fs) is less than 10 ms.

8. A method as claimed in Claim 7, in which during the tuning to the test frequency (fₛ) only the reception field strength is measured and in which, when the reception field strength (E(fₛ)) at the test frequency (fₛ) is smaller than at the listening reception frequency (fₕ), the test frequency (fₛ) is judged to be an unsuitable alternative frequency.

9. A radio receiver including a reception portion (2) tuneable to different frequencies (fₛ, fₕ) and which is constructed to emit an audio signal, a measurement circuit (9) for monitoring a parameter (Pₘ₁(tᵢ), Pₘ₂(tᵢ)) proportional to the power or the amplitude of the audio signal, and including a control unit (3) which is connected to the measurement circuit (9) and is constructed to analyse the audio signal in order to determine times at which interruption of the emission of the audio signal is not or is scarcely perceptible to a listener, and to determine whether a relative change in the proportional parameter (Pₘ₁(tᵢ)/Pₘ₂(tᵢ)) lies outside a desired range, **characterised in that** a time is determined to be suitable for the search when the relative change in this time (tᵢ) lies outside the desired range, so that the receiving portion (2) is tuned to search for an alternative frequency at a test frequency (fₛ) at a time thus determined.

10. A radio receiver as claimed in Claim 9, **characterised by** a noise generator (8) for supplying an audio output signal when the receiving portion (2) is tuned to a test frequency (fₕ) differing from a set listening reception frequency (fₕ).

## Revendications

1. Procédé pour la commande de la recherche d'une fréquence alternative à une fréquence d'audio-réception actuelle (fₕ) dans un récepteur radio, qui dérive un signal audio à partir d'un signal radio reçu à la fréquence d'audio-réception (fₕ),
dans lequel la réception du signal radio à la fréquence d'audio-réception (fₕ) est interrompue temporairement pour syntoniser le récepteur radio sur un signal radio à une fréquence d'analyse (fₛ) et pour contrôler si la fréquence d'analyse (fₛ) est appropriée à titre de fréquence alternative,
dans lequel le signal audio est évalué pour déterminer quels sont les moments pendant lesquels une interruption de l'émission du signal audio n'est pas perceptible ou est à peine perceptible pour un auditeur,
dans lequel l'évaluation comprend la surveillance d'une grandeur (Pₘ₁ (tᵢ), Pₘ₂ (tᵢ)) proportionnelle à l'amplitude ou à la puissance du signal audio,
**caractérisé en ce que** l'on détermine un moment qui est approprié à la recherche d'une fréquence alternative si la variation relative de la grandeur proportionnelle (Pₘ₁(tᵢ)/Pₘ₂ (tᵢ)) se situe à ce moment (tᵢ) en dehors d'un intervalle de consigne, où la syntonisation sur la fréquence d'analyse (fₛ) est réalisée à chaque fois à un moment ainsi déterminé.

2. Procédé selon la revendication 1, dans lequel la surveillance comprend
le calcul d'une valeur moyenne à long terme de la grandeur proportionnelle (Pₘ₁) du signal audio en faisant la moyenne avec une première constante temporelle et
le calcul d'une grandeur proportionnelle (Pₘ₂) à court terme, dans lequel on détermine un moment (tᵢ) qui est approprié à la recherche d'une fréquence alternative si le quotient constitué des grandeurs proportionnelles à court terme et à long terme (Pₘ₁ (tᵢ)/Pₘ₂ (tᵢ)) se situe en dehors d'un deuxième intervalle de consigne.

3. Procédé selon la revendication 2, dans lequel on ne détermine un moment qui est approprié à la recherche d'une fréquence alternative que si, en plus, une des grandeurs proportionnelles (Pₘ₁, Pₘ₂) se situe précisément au-dessus d'un troisième intervalle de consigne et/ou une des grandeurs proportionnelles se situe précisément en dessous du troisième intervalle de consigne.

4. Procédé selon la revendication 2 ou 3, dans lequel la première constante temporelle (T₁) se situe entre 2 et 20, de préférence entre 5 et 10 ms.

5. Procédé selon l'une des revendications 2 à 4, dans lequel la grandeur proportionnelle à court terme (Pₘ₂) est une grandeur proportionnelle du signal audio dont la moyenne a été faite avec une deuxième constante temporelle (T₂), où la deuxième constante temporelle (T₂) est inférieure à la première (T₁).

6. Procédé selon la revendication 5, dans lequel la deuxième constante temporelle (T₂) se situe entre 0,2 et 2, de préférence entre 0,5 et 1 ms.

7. Procédé selon l'une des revendications 1 à 6, dans lequel la durée de la syntonisation sur la fréquence d'analyse (f_{S}) est inférieure à 10 ms.

8. Procédé selon la revendication 7, dans lequel, pendant la syntonisation sur la fréquence d'analyse (fₛ), seule la force du champ de réception est mesurée, et dans lequel, si la force du champ (E(fₛ)) à la fréquence d'analyse (fₛ) est inférieure à la force du champ à la fréquence d'audio-réception (fₕ), la fréquence d'analyse (fₛ) est jugée être une fréquence alternative inadéquate.

9. Récepteur radio comprenant
une partie réception (2) pouvant être syntonisée sur des fréquences différentes (fₛ, fₕ) qui est conçue pour émettre un signal audio,
un circuit de mesure (9) pour surveiller une grandeur (Pₘ₁ (ti)/Pₘ₂ (tᵢ)) proportionnelle à la puissance ou à l'amplitude du signal audio, et comprenant
une unité de commande (3) reliée au circuit de mesure (9), qui est conçue
dans le but d'évaluer le signal audio, pour déterminer les moments pendant lesquels une interruption de l'émission du signal audio n'est pas perceptible ou est à peine perceptible pour un auditeur, et
de déterminer si une variation relative de la grandeur proportionnelle (Pₘ₁ (tᵢ)/Pₘ₂ (tᵢ)) se situe en dehors d'un intervalle de consigne, **caractérisé en ce que**
on détermine un moment qui est approprié pour la recherche, si la variation relative à ce moment (tᵢ) se trouve en dehors de l'intervalle de consigne si bien que la partie réception (2) pour la recherche d'une fréquence alternative est syntonisée sur une fréquence d'analyse (fₛ) à un moment ainsi déterminé.

10. Récepteur radio selon la revendication 9, **caractérisé par** un générateur de bruits (8) destiné à émettre un signal de sortie audio, si la partie réception (2) est syntonisée sur une fréquence d'analyse (fₛ) différente de la fréquence d'audio-réception réglée (fₕ).
